# EUROPÄISCHE PATENTSCHRIFT

(11) **EP 3 635 867 B1**
(45) Veröffentlichungstag und Bekanntmachung des Hinweises auf die Patenterteilung: **10.11.2021**
(21) Anmeldenummer: 19723143.4
(22) Anmeldetag: 15.05.2019
(51) Int. Cl.: H03K 17/94, H03K 17/96, H05K 5/00, H02B 1/46

(54) **WECHSELRICHTERGEHÄUSE MIT EINER OPTOELEKTRONISCHEN BEDIENEINHEIT**
INVERTER HOUSING WITH AN OPTOELECTRONIC OPERATING UNIT
BOÎTIER D'ONDULEUR AVEC UNE UNITÉ DE COMMANDE OPTOÉLECTRONIQUE

(30) Priorität: 19.06.2018 EP 18178578
(43) Veröffentlichungstag der Anmeldung: 15.04.2020
(73) Patentinhaber: FRONIUS INTERNATIONAL GmbH, 4643 Pettenbach (AT)
(72) Erfinder: GROSSAUER, Carina, 4643 Pettenbach (AT); GANGLMAIR, Sarim, 4643 Pettenbach (AT); MADERTHANER, Florian, 4643 Pettenbach (AT); LEITGEB, Ronald, 4643 Pettenbach (AT)
(74) Vertreter: SONN Patentanwälte OG
(86) Internationale Anmeldenummer: PCT/EP2019/062513
(87) Internationale Veröffentlichungsnummer: WO 2019/242944

(56) Entgegenhaltungen:
- WO-A2-2014/160908
- FR-A1- 2 866 194
- US-A1- 2013 193 314
- US-B2- 8 035 045

## Beschreibung

Die Erfindung betrifft ein Wechselrichtergehäuse mit zumindest zwei über Befestigungselemente lösbar miteinander verbindbaren Gehäuseteilen, einem Anschlussbereich und einem an einem Gehäuseteil vorgesehenen Bedienbereich.

Das US 8 035 045 B2 beschreibt ein Wechselrichtergehäuse mit zwei über Befestigungselemente lösbar miteinander verbindbaren Gehäuseteilen und einem Anschlussbereich.

Üblicherweise erfolgt die Bedienung von Vorrichtungen, beispielsweise von Wechselrichtern, wie Photovoltaik-Wechselrichtern, mithilfe mechanischer Bedienelemente, wie z.B. Tastern oder Schaltern. Mechanische Bedienelemente unterliegen einem gewissen Verschleiß und benötigen darüber hinaus relativ viel Platz auf der jeweiligen Vorrichtung, der nicht immer zur Verfügung steht. Darüber hinaus ist die Montage und Demontage mechanischer Bedienelemente durch die notwendigen Verdrahtungen relativ zeitaufwändig und darüber hinaus fehleranfällig.

Verbesserungen liefern dabei optoelektronische Bedieneinheiten, die den zusätzlichen Vorteil aufweisen, dass keine spannungsführenden Teile an den Bedienbereich der jeweiligen Vorrichtung, beispielsweise des Wechselrichters, geführt werden müssen und dadurch eine galvanische Trennung des Bedienelements zur jeweiligen Vorrichtung, beispielsweise des Wechselrichters, geschaffen wird.

Das EP 2 577 869 B1 beschreibt beispielsweise ein optoelektronisches Bedienelement, bei dem eine als Anzeige vorgesehene Leuchtdiode zur Durchführung von Schaltvorgängen verwendet wird, indem diese Leuchtdiode beispielsweise durch einen Finger eines Benutzers abgedunkelt wird. Auch bei dieser Variante einer Bedieneinheit ist jedoch die Verkabelung der als Bedienelement herangezogenen Leuchtdiode erforderlich, was einen entsprechenden Montage- und Demontageaufwand mit sich bringt.

Bei vielen Vorrichtungen, insbesondere auch Wechselrichtern, wie z.B. Photovoltaik-Wechselrichtern, befindet sich der Bedienbereich an der von außen zugänglichen Seite des Gehäuses der Vorrichtung, beispielsweise des Wechselrichtergehäuses, wohingegen die Platine mit der jeweiligen Elektronik und auch der Auswerteelektronik für die optoelektronische Bedieneinheit im gegenüberliegenden Teil des Gehäuses der Vorrichtung eingebaut ist. Im Falle eines Photovoltaik-Wechselrichters sind die notwendigen Anschlüsse für die Photovoltaik-Module und die Verbindung mit dem Versorgungsnetz oder den Verbrauchern meist am Rand der Platine in einem eigenen, vom Leistungsbereich getrennten Anschlussbereich angeordnet, von wo entsprechende Zuleitungen durch Öffnungen im Gehäuse zu den Photovoltaik-Modulen und zum Versorgungsnetz oder den Verbrauchern führen. Bei der Montage, Demontage und Wartung einer Vorrichtung, insbesondere eines Photovoltaik-Wechselrichters, ist ein Öffnen des Wechselrichtergehäuses notwendig, was bei einer Verkabelung der notwendigen Bedienelemente zu einem erhöhten Aufwand führt, da die Verbindungsleitungen zu dem jeweiligen Bedienelement gelöst werden müssen, bevor der Anschlussbereich im Gehäuse der Vorrichtung bzw. im Wechselrichtergehäuse frei zugänglich ist. Darüber hinaus müssen allfällige Verbindungsleitungen zu Bedienungselementen gegenüber Anschlussleitungen, beispielsweise zu Photovoltaik-Modulen oder dem Versorgungsnetz, entsprechend isoliert werden.

Bei Verwendung optoelektronischer Bedienelemente, wie z.B. gemäß der US 2003/0020004 A1 oder der US 2013/0193314 A1, können zwar mechanische Elemente, welche einem höheren Verschleiß unterliegen, vermieden werden, eine Verkabelung der Lichtquellen und Lichtdetektoren des Reflexions-Lichttasters zur jeweiligen Auswerteelektronik ist jedoch nach wie vor erforderlich und muss gegenüber spannungsführenden Teilen entsprechend isoliert und gesichert werden.

Auch die DE 10 2005 021 008 A1 beschreibt einen optischen Schalter oder Taster ohne jedoch auf die Anordnung in einem Gehäuse, insbesondere in einem Wechselrichtergehäuse, einzugehen. Die Methode nutzt zur Ausübung einer Schalterfunktion eine Störung des Evanescentfeldes aus.

Die Aufgabe der vorliegenden Erfindung besteht in der Schaffung eines Wechselrichtergehäuses, welches eine optimale Bedienung des Wechselrichters ermöglicht, und wobei der jeweilige Montage- und Demontageaufwand minimiert werden kann. Insbesondere soll ein Anschlussbereich eines Wechselrichters zum An- und Abschließen der Komponenten sowie der Überprüfung des Wechselrichters besonders einfach und rasch zugänglich sein. Nachteile bekannter optoelektronischer Bedieneinheiten und bekannter Wechselrichtergehäuse sollen vermieden oder zumindest reduziert werden.

Gelöst wird die erfindungsgemäße Aufgabe durch ein oben genanntes Wechselrichtergehäuse, wobei eine optoelektronische Bedieneinheit zur Bedienung des Wechselrichters, mit zumindest einem Reflexions-Lichttaster mit jeweils einer Lichtquelle und jeweils einem neben der Lichtquelle angeordneten Lichtdetektor, einer Auswerteelektronik, und mit einer über der Lichtquelle und dem Lichtdetektor jedes Reflexions-Lichttasters angeordneten Bedienfläche zur Bedienung des Reflexions-Lichttasters durch die Annäherung eines Objekts, vorgesehen ist, wobei zwischen jeder Bedienfläche und der Lichtquelle und dem Lichtdetektor eines Reflexions-Lichttasters ein mit einem Gehäuseteil verbundener Lichtleiter angeordnet ist, der andere Gehäuseteil eine Aufnahme für eine Platine, welche den Reflexions-Lichttaster der optoelektronischen Bedieneinheit enthält, aufweist, eine Signallichtquelle zur Aussendung von Licht im sichtbaren Wellenlängenbereich derart angeordnet ist, sodass das von der Signallichtquelle ausgesendete Licht im sichtbaren Wellenlängenbereich über den Lichtleiter auf die Bedienfläche projizierbar ist, und dass der Anschlussbereich unterhalb des Bedienbereichs angeordnet ist. Ein derartiges Wechselrichtergehäuse zeichnet sich durch einfache und kostengünstige Herstellung, aber auch geringeren Montage- und Demontageaufwand aus. Der zumindest eine Lichtleiter ist mit einem Gehäuseteil verbunden oder mit diesem einstückig hergestellt, wohingegen die Elektronik einschließlich des Reflexions-Lichttasters und der Auswerteelektronik im anderen Gehäuseteil befestigt ist. Eine entsprechende Konstruktion vorausgesetzt, müssen die Gehäuseteile lediglich miteinander verbunden werden und es wird automatisch eine Verbindung zwischen der Bedienfläche und dem Reflexions-Lichttaster hergestellt, indem der zumindest eine Lichtleiter die Distanz zwischen Bedienfläche und Reflexions-Lichttaster überbrückt. Es müssen keinerlei Arbeitsschritte zur Verbindung der optoelektronischen Bedieneinheit mit der Auswerteelektronik vorgenommen werden. Dementsprechend ist auch die Wartung einer mit einer solchen optoelektronischen Bedieneinheit ausgestatteten Vorrichtung, beispielsweise eines Wechselrichters, wesentlich vereinfacht, da bloß ein Gehäuseteil abgenommen werden muss und danach gleich der darunter angeordnete Anschlussbereich für die Wartung zugänglich ist. Verkabelungen für Bedienelemente müssen nicht, wie bisher üblich, vor der Wartung entfernt werden. Durch die Anordnung eines Lichtleiters zwischen Reflexions-Lichttaster und Bedienfläche kann der Reflexions-Lichttaster von der Bedienfläche entfernt angeordnet werden und somit die aufwändige Verkabelung des Reflexions-Lichttasters mit der jeweiligen Auswerteelektronik verhindert werden. Somit überbrückt der vorgesehene Lichtleiter zwischen Reflexions-Lichttaster und Bedienfläche die üblicherweise vorhandene Verkabelung, wodurch der Aufwand für die Herstellung und Demontage der Verkabelung entfällt. Weiters wird durch die zusätzliche Verwendung des Lichtleiters zur Übertragung des von einer Signallichtquelle ausgesendeten sichtbaren Lichts auf die Bedienfläche auf die Verkabelung für üblicherweise vorgesehene Signalleuchten und Anzeigen vermieden. Die Signallichtquelle kann als Signal zur Ausgabe eines Bestätigungssignals nach der Bedienung der optoelektronischen Bedieneinheit oder auch zur Anzeige bestimmter Betriebszustände der Vorrichtung herangezogen werden. Jedenfalls zeichnet sich die gegenständliche optoelektronische Bedieneinheit durch die Verwendung zumindest eines Lichtleiters sowohl für den Empfang der Bedieninformation als auch zur Ausgabe einer optischen Bestätigung oder eines optischen Signals aus. Die optoelektronische Bedieneinheit kann auch mehrere Reflexions-Lichttaster und mehrere Bedienflächen aufweisen, welche jeweils durch einen Lichtleiter miteinander verbunden sind. Die Reflexions-Lichttaster weisen jeweils zumindest eine Lichtquelle und zumindest einen Lichtdetektor auf, welche nebeneinander angeordnet sind und das Vorhandensein eines Objekts, beispielsweise eines Fingers eines Benutzers, detektieren können. Die Verwendung zumindest eines Lichtleiters in der vorliegenden optoelektronischen Bedieneinheit ermöglicht eine größere Designfreiheit bei der Gestaltung des Gehäuses der zu bedienenden Vorrichtung, beispielsweise des Wechselrichtergehäuses, und vermeidet die mit mechanischen Tasten oder Schaltern verbundene Problematik der Verkabelung zur Frontseite des Gehäuses. Neben den weiteren bekannten Vorteilen von optoelektronischen Bedieneinheiten, wie der galvanischen Trennung und der Robustheit gegenüber elektromagnetischen Einflüssen und mechanischem Verschleiß, sind derartige optoelektronische Bedieneinheiten auch flexibler, da mit einer Bedienfläche verschiedene Funktionen ausgelöst werden können, indem die Auswerteelektronik entsprechend ausgelegt und programmiert wird. Beispielsweise kann auch schon die Annäherung bzw. sogar die Annäherungsgeschwindigkeit des Fingers an die Bedienfläche detektiert werden. Die gegenständliche optoelektronische Bedieneinheit zeichnet sich durch einfachen Aufbau und niedrige Herstellungskosten aus. Vorteilhafter Weise ist die Bedienfläche bzw. der Lichtleiter mit der Bedienfläche zusammen mit einem Gehäuseteil des Wechselrichtergehäuses hergestellt. Dabei eignet sich vorzugsweise ein Zwei- oder Mehrkomponenten-Spritzgießverfahren zur Herstellung des entsprechenden Gehäuseteils. Bei Zwei- oder Mehrkomponenten-Spritzgießverfahren werden zwei oder mehrere verschiedene Kunststoffe hintereinander verarbeitet, wodurch dem hergestellten Gegenstand bestimmte Designs oder bestimmte Eigenschaften verliehen werden können. Beim gegenständlichen Wechselrichtergehäuse kann der Gehäuseteil beispielsweise durch einen geeigneten undurchsichtigen Kunststoffwerkstoff, beispielsweise Polypropylen, hergestellt werden, wohingegen für den zumindest einen Lichtleiter vorzugsweise Polycarbonate verwendet werden. Beim Vorsehen mehrerer Lichtleiter für die Verbindung mehrerer Bedienflächen mit mehreren Reflexions-Lichttastern können diese Lichtleiter auch über zumindest einen gemeinsamen Steg miteinander verbunden werden, wodurch die mechanische Stabilität der Lichtleiter und des damit verbundenen Gehäuseteils erhöht werden kann.

Zwischen den zumindest zwei Gehäuseteilen kann eine Dichtung angeordnet sein. Insbesondere bei einer Verwendung des Gehäuses im Außenbereich, wie es bei Wechselrichtergehäusen üblich ist, ist eine solche Dichtung unbedingt erforderlich bzw. vorteilhaft, um die Lebensdauer der im Wechselrichtergehäuse enthaltenen elektronischen Komponenten zu erhöhen. Die Dichtung kann im einfachsten Fall durch ein umlaufendes Band oder dergleichen aus elastischem Material, wie z.B. Silikon, gebildet sein.

Wenn die Signallichtquelle der optoelektronischen Bedieneinheit zwischen der Lichtquelle und dem Lichtdetektor eines Reflexions-Lichttasters angeordnet ist, kann einerseits Platz gespart werden und andererseits durch die Signallichtquelle eine Trennung zwischen Lichtquelle und Lichtdetektor des Reflexions-Lichttasters geschaffen werden. Die Signallichtquelle zur Aussendung eines Bestätigungssignals für die Bestätigung einer Bedienung der optoelektronischen Bedieneinheit ist somit in der Mitte des Reflexions-Lichttasters angeordnet, wodurch derselbe Lichtleiter der zur Weiterleitung des Lichts des Reflexions-Lichttasters angeordnet ist, auch zur Leitung des Lichts der Signallichtquelle herangezogen werden kann. Das Licht der Signallichtquelle wird dann auf die Bedienfläche, welche gleichzeitig zur Bedienung der optoelektronischen Bedieneinheit dient, projiziert. Bei der Verwendung der Signallichtquelle zur Abgabe eines Feedback-Signals für die Bedienung der optoelektronischen Bedieneinheit ist diese Anordnung besonders vorteilhaft, da die ordnungsgemäße Bedienung der optoelektronischen Bedieneinheit durch Beleuchten der Bedienfläche besonders deutlich angezeigt werden kann. Die Reflexions-Lichttaster allenfalls zusammen mit einer oder mehreren Signallichtquellen können in heute üblichen Halbleitertechnologien besonders klein und platzsparend aber auch kostengünstig hergestellt werden.

Gemäß einem Merkmal der Erfindung ist die Bedienfläche der optoelektronischen Bedieneinheit durch den Lichtleiter gebildet. In diesem Fall wird die Stirnseite des Lichtleiters selbst als Bedienfläche verwendet, weshalb kein eigener Bauteil zur Bildung der Bedienfläche vorgesehen werden muss. Durch die Gestaltung des Querschnitts des Lichtleiters kann auf die Größe und Form der Bedienfläche Einfluss genommen werden.

Die Lichtquelle und der Lichtdetektor des Reflexions-Lichttasters können durch eine Infrarot-Leuchtdiode und einen Infrarotdetektor, vorzugsweise mit Sende- bzw. Detektionsmaxima bei einer Wellenlänge zwischen 850nm und 900nm, gebildet sein. Diese Wellenlängenbereiche sind für die Detektion vorteilhaft, da das sichtbare Umgebungslicht weniger Einfluss auf die Detektion hat. Auch kann bei Verwendung von Infrarotlicht eine höhere Empfindlichkeit der optoelektronischen Bedieneinheit erzielt werden.

Wenn die Signallichtquelle zur Aussendung von Licht im sichtbaren Wellenlängenbereich durch eine RGB-Leuchtdiode gebildet ist, kann die Signallichtquelle zur Aussendung von Signalen in verschiedenen Farben herangezogen werden. Mehrfarbige RGB-Leuchtdioden, welche rote, grüne und blaue Leuchtdioden kombinieren, können durch entsprechende Mischung der Intensitäten der einzelnen Leuchtdioden zur Aussendung verschiedenster Farben verwendet werden. Derartige Leuchtdioden sind mittlerweile auch besonders kostengünstig erhältlich.

Der Lichtleiter der optoelektronischen Beideneinheit ist idealerweise aus Polycarbonaten gebildet und vorzugsweise im Spritzgießverfahren hergestellt. Polycarbonate sind thermoplastische Kunststoffe, die relativ leicht verarbeitet werden können und darüber hinaus Licht besonders gut leiten können bzw. für Licht entsprechend durchlässig sind. Darüber hinaus lassen sich Polycarbonate auch einfärben, wodurch die Gestaltungsmöglichkeiten der optoelektronischen Bedieneinheit oder des mit der optoelektronischen Bedieneinheit ausgestatteten Gehäuses noch weiter erhöht werden können.

Alternativ dazu kann der Lichtleiter auch aus anderen lichtdurchlässigen und lichtleitenden Materialien, wie z.B. Glas, hergestellt sein. Glas ist zwar aufwändiger in der Herstellung, kann aber hinsichtlich einer Alterung gegenüber Kunststoffen vorteilhaft sein.

Zusätzlich kann ein Lichtsensor zur Detektion von Umgebungslicht vorgesehen und vorzugsweise neben dem Reflexions-Lichttaster angeordnet sein, welcher Lichtsensor mit der Auswerteelektronik verbunden ist. Durch die Anordnung eines Lichtsensors zur Detektion des Umgebungslichts kann die Lichtstärke der Signallichtquelle an das Umgebungslicht angepasst werden, ähnlich wie es bei der Helligkeit des Bildschirms von Anzeigen, beispielsweise von Smartphones, bekannt ist. Wenn der Lichtsensor zur Detektion von Umgebungslicht neben dem Reflexions-Lichttaster angeordnet ist, kann dieser das über den Lichtleiter eindringende Umgebungslicht analysieren und auswerten. Alternativ dazu kann der Lichtsensor zur Detektion von Umgebungslicht auch an einer anderen geeigneten Stelle des Gehäuses der Vorrichtung, welche mit der optoelektronischen Bedieneinheit versehen wird, angeordnet werden.

Wenn die Aufnahme für die Platine derart vorgesehen ist, dass die Platine in einem Winkel zwischen 10° und 170°, vorzugsweise im Wesentlichen 90°, zur Bedienfläche angeordnnet ist, kann ein flexiblerer Einbau der optoelektronischen Bedieneinheit im Wechselrichtergehäuse erzielt werden. Eine im Wesentlichen senkrechte Anordnung zwischen Bedienfläche und Reflexions-Lichttaster ist bei vielen praktischen Anwendungen von Vorteil, wenn die Frontfläche bzw. Bedienfläche einer Vorrichtung im Wesentlichen senkrecht zur Platine, welche auch die Auswerteelektronik der optoelektronischen Bedieneinheit und den Reflexions-Lichttaster aufweist, angeordnet ist.

Vorzugsweise sind die Bedienfläche und bzw. oder die Umlenkfläche des Lichtleiters poliert ausgebildet. Durch das Polieren der Bedienfläche kann die Empfindlichkeit der optoelektronischen Bedieneinheit erhöht werden, da weniger Streulicht eingefangen wird, das Einfluss auf die Empfindlichkeit der Auslösung des Reflexions-Lichttasters haben könnte. Bei der Umlenkfläche zum Umlenken des Lichts im Lichtleiter hat sich ein Polieren ebenfalls als vorteilhaft herausgestellt, da dadurch die Reflexionseigenschaften des im Lichtleiter transportierten Lichts verbessert und Verluste minimiert werden können. In der Folge resultieren auch längere Strecken die mit dem Lichtleiter zwischen der Bedienfläche und dem Reflexions-Lichttaster überbrückt werden können.

Vorteilhafterweise ist jedes Befestigungselement durch einen Drehbolzen und eine Blattfeder mit einer Öffnung für die Aufnahme eines Endes des Drehbolzens gebildet, wobei der Drehbolzen in der geöffneten Stellung aus der bzw. in die Öffnung der Blattfeder bringbar ist, und in einer gegenüber der geöffneten Stellung verdrehten, geschlossenen Stellung die Blattfeder vorgespannt in axialer Richtung fixiert. Durch diese Ausbildung des Befestigungselements kann eine einfache und rasche Befestigung der Gehäuseteile des Wechselrichtergehäuses erzielt werden und somit die Montage und Demontage erleichtert werden. Zugleich kann durch die entsprechende Ausgestaltung der Befestigungselemente eine optimale Dichtheit des Wechselrichtergehäuses erzielt werden, welche auch meist erforderlich ist, da Wechselrichtergehäuse im Allgemeinen für die Anordnung im Außenbereich konzipiert sind. Die Betätigung des Drehbolzens jedes Befestigungselements kann manuell durch entsprechende Ausgestaltung des Kopfes des Drehbolzens erfolgen oder auch mithilfe eines geeigneten Werkzeugs, wie z.B. eines Schraubenziehers, der in eine dafür vorgesehene Aufnahme am Kopf des Drehbolzens eingebracht werden kann.

Dabei rastet der Drehbolzen jedes Befestigungselements in der geschlossenen Stellung bevorzugt in die Öffnung der Blattfeder ein. Durch das Ein- oder Verrasten des Drehbolzens in der Blattfeder wird einerseits ein Halten in der geschlossenen Stellung unterstützt und ein ungewolltes Öffnen des Befestigungselements verhindert. Andererseits kann durch entsprechende Ausgestaltung der Blattfeder und des Gehäuseteils erreicht werden, dass beim Einrasten des Drehbolzens in der geschlossenen Stellung ein akustisches Signal durch die Blattfeder in Kombination mit dem Gehäuseteil abgegeben und ein Widerstand erzeugt wird, der beim Schließen des Befestigungselements mit einem spürbaren Ruck überwunden werden muss. Dadurch wird dem Monteur das ordnungsgemäße Einrasten in der geschlossenen Stellung angezeigt. Somit muss der Monteur das Befestigungselement so lange betätigen, beispielsweise eine Vierteldrehung, bis er das akustische Signal hört und die Überwindung des Widerstands spürt, um sicherzustellen, dass sich das Befestigungselement ordnungsgemäß in der geschlossenen Stellung befindet. Wie oben beschrieben, kann das akustische Signal und der spürbare Widerstand ebenso beim Öffnen des Befestigungselements hervorgerufen werden.

Vorteilhafterweise ist im unteren Bereich jedes Drehbolzens eine Kulisse mit einer Rastnase angeordnet, und weist die Öffnung jeder Blattfeder Rastnasen auf, sodass bei Verdrehung des Drehbolzens um 90° eine sichere Verbindung der Gehäuseteile unter Vorspannung der Blattfeder gewährleistet wird. Durch entsprechende Gestaltung der Rastnase am Drehbolzen und der Blattfeder und deren Vorspannung zusammen mit dem Gehäuseteil kann erzielt werden, dass ein akustisches Signal beim Einrasten des Drehbolzens in der verschlossenen Stellung und allenfalls Öffnen des Drehbolzens erzeugt wird, das dem Monteur das ordnungsgemäße Erreichen der geschlossenen bzw. geöffneten Stellung anzeigt. Auch spürt der Monteur das Überwinden der Rastnase durch einen entsprechenden Ruck, wenn die geschlossene bzw. geöffnete Stellung des Befestigungselements erreicht wurde.

Gemäß einem weiteren Merkmal ist die Blattfeder jedes Befestigunsgelements aus gehärtetem Metall gebildet.

Die Erfindung wird anhand der beigefügten Zeichnungen näher erläutert. Darin zeigen:
- Fig. 1: eine in einem Teil eines Wechselrichtergehäuses eingebaute optoelektronische Bedieneinheit der vorliegenden Erfindung in geschnittener Darstellung;
- Fig. 2: eine Ansicht auf den Reflexions-Lichttaster der optoelektronischen Bedieneinheit gemäß Fig. 1;
- Fig. 3: eine Draufsicht auf die Bedienfläche der optoelektronischen Bedieneinheit gemäß Fig. 1;
- Fig. 4: das Prinzip eines Wechselrichtergehäuses in Explosionsdarstellung;
- Fig. 5: das Wechselrichtergehäuse gemäß Fig. 4 in zusammengebautem Zustand;
- Fig. 6: eine Explosionsdarstellung einer Ausführungsform eines Befestigungselements zur Befestigung der Gehäuseteile eines Wechselrichtergehäuses;
- Fig. 7: das Befestigungselement gemäß Fig. 6 im zusammengebauten Zustand der Gehäuseteile des Wechselrichtergehäuses;
- Fig. 8: eine Draufsicht auf die Blattfeder des Befestigungselements gemäß den Figuren 6 und 7;
- Fig. 9: eine Variante des Lichtleiters der optoelektronischen Bedieneinheit gemäß Fig. 1 in perspektivischer Ansicht;
- Fig. 10: eine perspektivische Ansicht auf eine Ausführungsform eines Lichtwellenleiters einer optoelektronischen Bedieneinheit mit Elementen zur Zentrierung einer Platine, welche den Reflexions-Lichttaster enthält; und
- Fig. 11: ein Schnittbild durch die Anordnung gemäß Fig. 10 mit daran angeschlossener Platine.

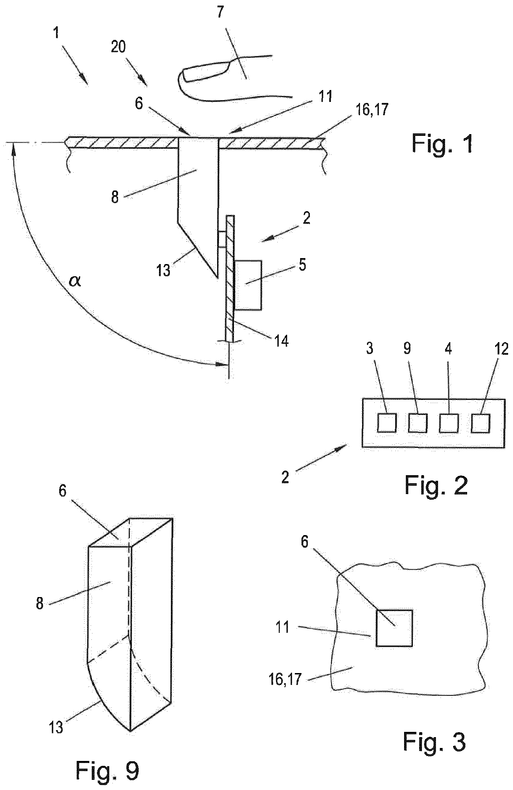

Fig. 1 zeigt eine in einem Teil eines Wechselrichtergehäuses 15 eingebaute optoelektronische Bedieneinheit 1 der vorliegenden Erfindung in geschnittener Darstellung. In einem Gehäuseteil 16 oder 17 des Wechselrichtergehäuses 15 ist zur Bildung des Bedienbereichs 20 eine optoelektronische Bedieneinheit 1 angeordnet, welche zumindest einen Reflexions-Lichttaster 2 aufweist, der jeweils zumindest eine Lichtquelle 3 und jeweils einen neben der Lichtquelle 3 angeordneten Lichtdetektor 4 beinhaltet (s. Fig. 2). Der Reflexions-Lichttaster 2 ist mit einer entsprechenden Auswerteelektronik 5 verbunden und wird über eine Bedienfläche 6 durch Annäherung eines Objekts 7, beispielsweise eines Fingers eines Bedieners, entsprechend betätigt. Erfindungsgemäß ist zwischen jeder Bedienfläche 6 und der Lichtquelle 3 und dem Lichtdetektor 4 eines Reflexions-Lichttasters 2 ein Lichtleiter 8 angeordnet, über den das Licht der Lichtquelle 3 des Reflexions-Lichttasters 2 zur Bedienfläche 6 und von dort zurück zum Lichtdetektor 4 geleitet werden kann. Im Falle einer Umlenkung der Richtung des Lichts ist eine entsprechende Umlenkfläche 13 im Lichtleiter 8 angeordnet. Die Bedienfläche 6 kann gesondert ausgebildet sein oder durch die Stirnfläche des Lichtleiters 8 gebildet werden. Im dargestellten Ausführungsbeispiel ist der Reflexions-Lichttaster 2 und die entsprechende Auswerteelektronik 5 auf einer Platine 14 angeordnet, die hier in einem Winkel α von im Wesentlichen 90° zur Bedienfläche 6 angeordnet ist. Die Bedienfläche 6 ist eben mit der Fläche des Gehäuseteils 16 oder 17 ausgebildet. Durch die Umlenkfläche 13 des Lichtleiters 8 wird das Licht um diesen Winkel α entsprechend umgelenkt. Bei der Realisierung anderer Winkel α muss der Lichtleiter 8 nur entsprechend umgestaltet werden, sodass eine entsprechende Umlenkung des Lichts des Reflexions-Lichttasters 2 zur Bedienfläche 6 ermöglicht wird. Auf der Platine 14, vorzugsweise zwischen der Lichtquelle 3 und dem Lichtdetektor 4 des Reflexions-Lichttasters 2 (s. Fig. 2) ist eine Signallichtquelle 9 angeordnet, dessen Licht im sichtbaren Wellenlängenbereich ebenfalls über den Lichtleiter 8 auf die Bedienfläche 6 projizierbar ist. Die Lichtquelle 3 und der Lichtdetektor 4 des Reflexions-Lichttasters 2 ist vorzugsweise durch eine Infrarot-Leuchtdiode und einen Infrarotdetektor, vorzugsweise mit Sende- bzw. Detektionsmaxima, bei einer Wellenlänge λ zwischen 850 nm und 900 nm gebildet. Die Signallichtquelle 9 kann beispielsweise durch eine RGB-Leuchtdiode gebildet sein, um die Aussendung verschiedenfarbigen Lichts zu ermöglichen.

Der Lichtleiter 8 ist vorzugsweise aus Polycarbonaten gebildet und vorzugsweise im Spritzgießverfahren hergestellt. Eine Herstellung aus Glas ist jedoch ebenso möglich. Vorzugsweise neben dem Reflexions-Lichttaster 2 bzw. neben dessen Lichtquelle 3 oder Lichtdetektor 4 kann ein Lichtsensor 12 zur Detektion von Umgebungslicht vorgesehen und vorzugsweise mit der Auswerteelektronik 5 verbunden sein.

Wie der Draufsicht auf die Bedienfläche 6 gemäß Fig. 3 entnommen werden kann, ist die Bedienfläche 6 gegenüber der umgebenden Fläche 11 vorzugsweise mit einer anderen Beschaffenheit ausgebildet, vorzugsweise poliert, sodass einerseits die Bedienfläche 6 von der umgebenen Fläche 11 abgehoben dargestellt und andererseits die Empfindlichkeit der optoelektronischen Bedieneinheit 1 erhöht werden kann.

Die Auswertung des Reflexions-Lichttasters 2 in der Auswerteelektronik 5 wird vorzugsweise softwaremäßig vorgenommen, indem die Dauer und der Grad der Abdunkelung der Bedienfläche 6 durch das Objekt 7 erfasst und mit voreingestellten Werten verglichen werden. Dadurch können verschiedene Bedienmuster abgefragt und verschiedene Funktionen der Vorrichtung ausgelöst werden. Beispielsweise kann ein langes oder kurzes Abdunkeln der Bedienfläche 6 durch ein Objekt 7 oder ein mehrfaches Abdecken der Bedienfläche 6 durch ein Objekt 7 innerhalb einer vorgegebenen Zeitspanne detektiert werden und zum Auslösen bestimmter Funktionen der Vorrichtung herangezogen werden.

Die dargestellte optische Bedieneinheit 1 zeichnet sich durch einen verringerten Montage- und Demontageaufwand aus, da keine Verkabelung zwischen dem Bedienbereich 20 am Gehäuseteil 16 oder 17 und dem Reflexions-Lichttaster 2 bzw. der Auswerteelektronik 5 hergestellt werden muss, wenn die Gehäuseteile 16, 17 gelöst werden, um die Vorrichtung zu montieren oder demontieren oder eine Wartung vornehmen zu können. Die Länge und Gestaltung des Lichtleiters 8 ist in relativ weiten Grenzen möglich und der Lichtleiter 8 und der entsprechende Gehäuseteil 16 oder 17 können relativ einfach und kostengünstig in einem Herstellungsverfahren hergestellt werden oder der Lichtleiter 8 kann relativ einfach am Gehäuseteil 16, 17 angebracht werden.

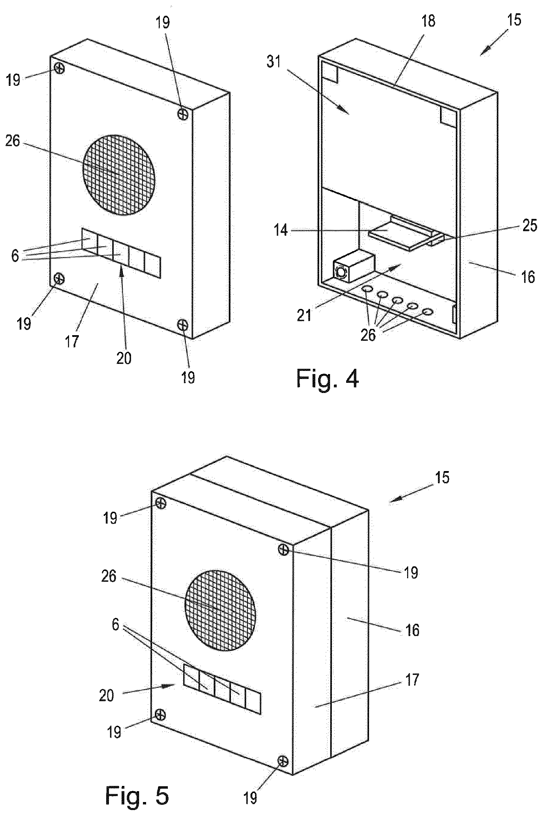

Fig. 4 zeigt das Prinzip eines Wechselrichtergehäuses 15, wie es für einen Photovoltaik-Weschselrichter eingesetzt wird, in Explosionsdarstellung. Das Wechselrichtergehäuse 15 besteht im Wesentlichen aus zwei Gehäuseteilen 16, 17, welche über entsprechende Befestigungselemente 19 miteinander lösbar verbunden werden können. An dem einen Gehäuseteil 16 des Wechselrichtergehäuses 15, welches üblicherweise an einer Wand oder dergleichen (nicht dargestellt) montiert wird, befindet sich üblicherweise im unteren Bereich ein Anschlussbereich 21, welcher von einem Leistungsbereich 31, der die leistungselektronischen Komponenten des Wechselrichters aufweist, getrennt ist. Im Anschlussbereich 21 erfolgt der Anschluss der Photovoltaik-Module mit dem DC-Eingang des Wechselrichters und der Verbraucher bzw. des Versorgungsnetzes mit dem AC-Ausgang des Wechselrichters über entsprechende Steckverbindungen oder dergleichen (nicht dargestellt). Über entsprechende Öffnungen 26 im Gehäuseteil 16 verlaufen die entsprechenden Zuleitungen zu den Photovoltaik-Modulen und Verbrauchern bzw. dem Verbrauchernetz. Im Anschlussbereich 21 des Gehäuseteils 16 befinden sich Aufnahmen 25 für eine Platine 14, welche die notwendigen Komponenten der optoelektronischen Bedieneinheit 1, wie die Reflexions-Lichttaster 2 und die Auswerteelektronik 5, enthalten. Über eine Dichtung 18 werden die beiden Gehäuseteile 16, 17 im geschlossenen Zustand entsprechend abgedichtet.

Im vorderen Gehäuseteil 17 des Wechselrichtergehäuses 15 sind die Befestigungselemente 19 entsprechend angeordnet und im Bedienbereich 20 befinden sich die Bedienelemente zur Bedienung des Wechselrichters. Erfindungsgemäß befinden sich die Bedienflächen 6 der optoelektronischen Bedieneinheit 1 (s. Fig. 1-3) im Bedienbereich 20 des Gehäuseteils 17, sodass eine einfache und unkomplizierte Bedienung der Funktionen des Wechselrichters ermöglicht wird. Gleichzeitig dienen die Bedienflächen 6 zur Ausgabe optischer Signale über die Signallichtquellen 9 über die entsprechenden Bedienflächen 6.

Vorteilhaft ist auch, dass der Bedienbereich 20 über dem Anschlussbereich 21 im anderen Gehäuseteil 16 angeordnet ist, sodass die Komponenten der optoelektronischen Bedieneinheit 1 auch keine Störung der Verkabelungen im Anschlussbereich 21 bewirken. Ebenso kann der Gehäuseteil 17 oder auch nur ein Teil davon, wie z.B. ein entsprechend gestalteter Deckel (nicht dargestellt), in einfacher Weise geöffnet und geschlossen werden, um einen Zugang zum Anschlussbereich 21 zu ermöglichen. Der Gehäuseteil 17 kann auch zwei- oder mehrteilig ausgebildet sein, sodass beispielsweise der Anschlussbereich 21 und der Leistungsbereich 31 getrennt voneinander geöffnet werden kann.

Fig. 5 zeigt das Wechselrichtergehäuse 15 gemäß Fig. 4 in zusammengebautem Zustand. Im geschlossenen Zustand des Wechselrichtergehäuses 15 befinden sich die beiden Gehäuseteile 16, 17 entsprechend übereinander und die Befestigungselemente 19 werden in die verschlossene Stellung gebracht. Somit kann der Wechselrichter über die Bedienflächen 6 der optoelektronischen Bedieneinheit gesteuert oder ein- und ausgeschaltet werden. Bei ordnungsgemäßer Befestigung der Befestigungselemente 19 wird eine entsprechende Dichtheit zwischen den beiden Gehäuseteilen 16, 17 erzielt, welche durch die in Fig. 4 dargestellte und beschrieben Dichtung 18 gewährleistet bzw. verbessert wird.

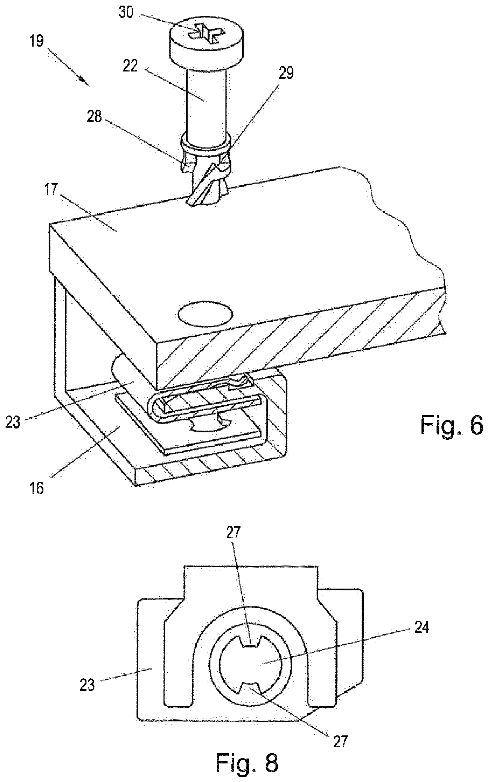

Fig. 6 zeigt eine Explosionsdarstellung einer Ausführungsform eines Befestigungselements 19 zur Befestigung der Gehäuseteile 16, 17 eines Wechselrichtergehäuses 15. Die beiden Gehäuseteile 16, 17 werden über das Befestigungselement 19 miteinander verbunden, wobei das Befestigungselement 19 aus einem Drehbolzen 22 und einer Blattfeder 23 besteht. Der Drehbolzen 22 weist am Kopf eine Aufnahme 30 für ein entsprechendes Werkzeug, beispielsweise einen Schraubzieher (nicht dargestellt), auf. Im unteren Bereich des Drehbolzens 22 ist eine Kulisse 28 angeordnet, mit einer Rastnase 29, die in eine entsprechende Öffnung 24 mit Rastnasen 27 in der Blattfeder 23 (s. Fig. 8) einrastet und bei Verdrehung um 90° eine sichere Verbindung der beiden Gehäuseteile 16 und 17 unter Vorspannung der Blattfeder 23 gewährleistet. Durch entsprechende Gestaltung der Rastnase 29 am Drehbolzen 22 und der Blattfeder 23 und deren Vorspannung zusammen mit dem Gehäuseteil 16 kann erzielt werden, dass ein akustisches Signal beim Einrasten des Drehbolzens 22 in der verschlossenen Stellung und allenfalls Öffnen des Drehbolzens 22 erzeugt wird, das dem Monteur das ordnungsgemäße Erreichen der geschlossenen bzw. geöffneten Stellung anzeigt. Auch spürt der Monteur das Überwinden der Rastnase 29 durch einen entsprechenden Ruck, wenn die geschlossene bzw. geöffnete Stellung des Befestigungselements 19 erreicht wurde. Idealerweise wird die Blattfeder 23 aus gehärtetem Metall, insbesondere Saarstahl C67S, hergestellt und weist im parallelen Zustand vorzugsweise eine Kraft von 100N bis 150N, insbesondere 125N auf. Der Gehäuseteil 16 ist vorzugsweise aus Aluminium im Druckgussverfahren hergestellt. Der Gehäuseteil 17 kann auch aus Kunststoff bestehen.

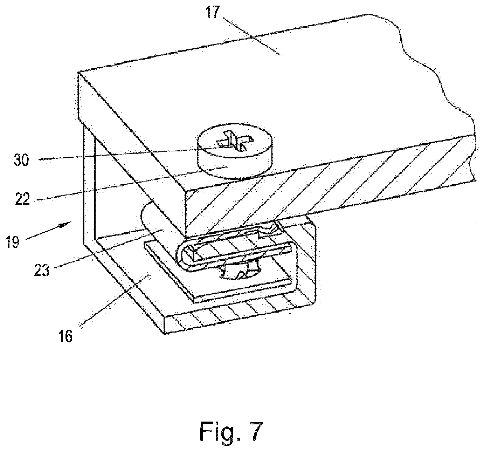

Fig. 7 zeigt das Befestigungselement 19 gemäß Fig. 6 im zusammengebauten Zustand der Gehäuseteile 16, 17 des Wechselrichtergehäuses 15. Durch die Vorspannung der Blattfeder 23 und dem in geschlossene Stellung gedrehten Befestigungselement 19 wird der Gehäuseteil 16 gegenüber dem Gehäuseteil 17 entsprechend verspannt, wodurch allenfalls unter Zwischenlage einer Dichtung 18 (nicht dargestellt) eine optimale Dichtheit für das Wechselrichtergehäuse 15 erzielt werden kann. Die Vorspannung der Blattfedern 23 bewirkt, dass durch die Befestigungselemente 19 die zur Erzielung einer entsprechenden Dichtheit des Wechselrichtergehäuses 15 notwendige Kraft aufgebaut werden kann. Auch erfolgt das Einrasten des Befestigungselements 19 in die geschlossene Stellung durch die Vorspannung der Blattfeder 23 mit einer erhöhten Kraft und Beschleunigung, wodurch auch das akustische Signal beim Einrasten in die geschlossene bzw. auch geöffnete Stellung verstärkt wird.

Schließlich zeigt Fig. 9 eine Variante des Lichtleiters 8 der optoelektronischen Bedieneinheit 1 gemäß Fig. 1 in perspektivischer Ansicht. Bei dieser Variante ist gegenüber der Ausführungsform gemäß Fig. 1 die Umlenkfläche 13 des Lichtleiters 9 gewölbt ausgebildet, was zu einer Verbesserung der Führung des Lichts innerhalb des Lichtleiters 8 führen kann. Wie bereits bei der Ausführungsvariante des Lichtleiters 8 gemäß Fig. 1 erwähnt, ist die Umlenkfläche 13 vorzugsweise poliert ausgebildet. Der Gestaltung des Lichtleiters 8 sind jedoch kaum Grenzen gesetzt.

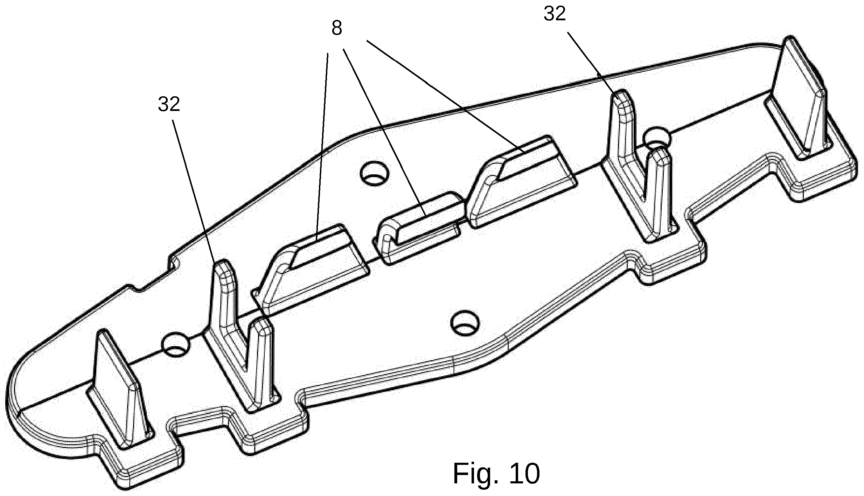

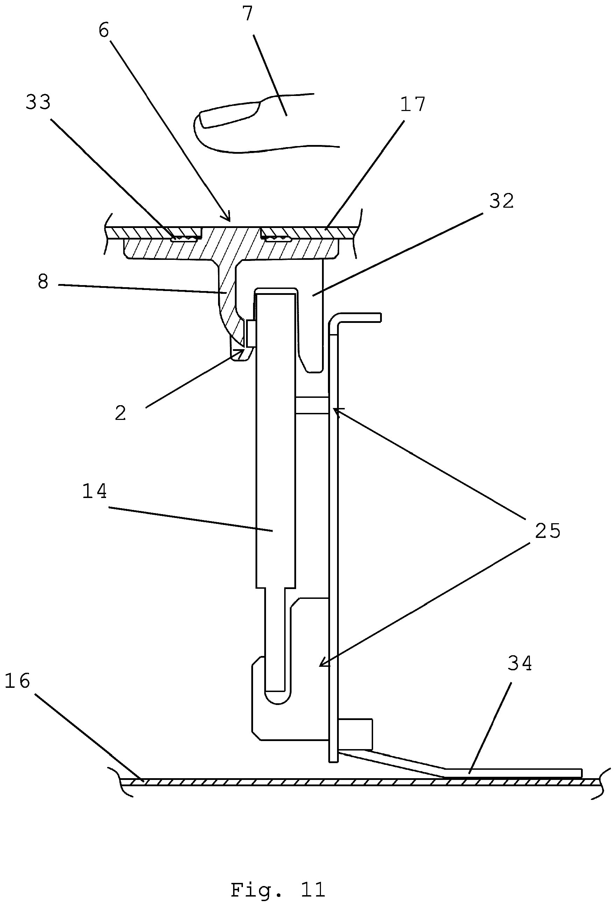

Fig. 10 zeigt eine perspektivische Ansicht auf eine Ausführungsform eines Lichtleiters 8 einer optoelektronischen Bedieneinheit 1 mit Elementen 32 zur Zentrierung einer Platine 14, welche den Reflexions-Lichttaster 2 enthält. Die Zentrierelemente 32 werden vorzugsweise gemeinsam mit den Lichtleitern 8 und der Bedienfläche 6, beispielsweise in einem Mehrkomponenten-Spritzgussverfahren, hergestellt. Eine allfällige Dichtung 33 aus weichem Material um der Bedienfläche 6 kann auch in diesem Herstellungsvorgang vorgesehen werden. Diese Dichtung 33 (siehe Fig. 11) stellt sicher, dass zwischen der Bedienfläche 6 uund dem Gehäuseteil 17 keine Feuchtigkeit in das Wechselrichtergehäuse 15 eindringen kann.

Aus dem Schnittbild gemäß Fig. 11 ist die Anordnung der Platine 14 in den Zentrierelementen 32 der optoelektronischen Bedieneinheit 1 besser ersichtlich. Dementsprechend ist der Lichtleiter 8 zusammen mit der Bedienfläche 6 im Gehäuseteil 17 angeordnet, wobei eine Dichtung 33 aus elastischerem Material angeordnet sein kann. Beim Schließen des Gehäuseteils 17, was auch durch ein Verschwenken gegenüber dem anderen Gehäuseteil 16 geschehen kann, wird die Platine 14 mit dem daran angeordneten Reflexions-Lichttaster 2 über die Zentrierelemente 32 am Lichtleiter 8 in die gewünschte Position gebracht, sodass der untere Teil des Lichtleiter 8 den Reflexions-Lichttaster 2 entsprechend berührt oder beabstandet und Licht zwischen Bedienfläche 6 und Reflexions-Lichttaster 2 über den Lichtleiter 8 geleitet werden kann. Wenn die Aufnahme 25 für die Platine 14 im Gehäuseteil 16 über entsprechend gestaltete Federelemente 34 federnd gelagert ist, kann eine noch bessere Zuordnung des Lichtleiters 8 in Bezug auf die Platine 14 erzielt werden und es können noch größere Toleranzen ausgeglichen werden, ohne dabei die Platine 14 oder den Lichtleiter 8 übermäßig zu verspannen.

## Patentansprüche

1. Wechselrichtergehäuse (15) für einen Wechselrichter (10) mit zumindest zwei über Befestigungselemente (19) lösbar miteinander verbindbaren Gehäuseteilen (16, 17), einem Anschlussbereich (21) und einem an einem Gehäuseteil (16, 17) vorgesehenen Bedienbereich (20), wobei eine optoelektronische Bedieneinheit (1) zur Bedienung des Wechselrichters (10), mit zumindest einem Reflexions-Lichttaster (2) mit jeweils einer Lichtquelle (3) und jeweils einem neben der Lichtquelle (3) angeordneten Lichtdetektor (4), einer Auswerteelektronik (5), und mit einer über der Lichtquelle (3) und dem Lichtdetektor (4) jedes Reflexions-Lichttasters (2) angeordneten Bedienfläche (6) zur Bedienung des Reflexions-Lichttasters (2) durch die Annäherung eines Objekts (7), vorgesehen ist, wobei zwischen jeder Bedienfläche (6) und der Lichtquelle (3) und dem Lichtdetektor (4) eines Reflexions-Lichttasters (2) ein mit einem Gehäuseteil (17) verbundener Lichtleiter (8) angeordnet ist, der andere Gehäuseteil (16) eine Aufnahme (25) für eine Platine (14), welche den Reflexions-Lichttaster (2) der optoelektronischen Bedieneinheit (1) enthält, aufweist, eine Signallichtquelle (9) zur Aussendung von Licht im sichtbaren Wellenlängenbereich derart angeordnet ist, sodass das von der Signallichtquelle (9) ausgesendete Licht im sichtbaren Wellenlängenbereich über den Lichtleiter (8) auf die Bedienfläche (6) projizierbar ist, und dass der Anschlussbereich (21) unterhalb des Bedienbereichs (20) angeordnet ist.

2. Wechselrichtergehäuse (15) nach Anspruch 1, **dadurch gekennzeichnet, dass** die Bedienfläche (6) bzw. der Lichtleiter (8) mit der Bedienfläche (6) zusammen mit einem Gehäuseteil (16, 17), vorzugsweise im Zwei- oder Mehrkomponenten-Spritzgießverfahren, hergestellt ist.

3. Wechselrichtergehäuse (15) nach Anspruch 1 oder 2, **dadurch gekennzeichnet, dass** zwischen den zumindest zwei Gehäuseteilen (16, 17) eine Dichtung (18) angeordnet ist.

4. Wechselrichtergehäuse (15) nach einem der Ansprüche 1 bis 3, **dadurch gekennzeichnet, dass** die Signallichtquelle (9) der optoelektronischen Bedieneinheit (1) zwischen der Lichtquelle (3) und dem Lichtdetektor (4) eines Reflexions-Lichttasters (2) angeordnet ist.

5. Wechselrichtergehäuse (15) nach einem der Ansprüche 1 bis 4, **dadurch gekennzeichnet, dass** die Bedienfläche (6) der optoelektronischen Bedieneinheit (1) durch den Lichtleiter (8) gebildet ist.

6. Wechselrichtergehäuse (15) nach einem der Ansprüche 1 bis 5, **dadurch gekennzeichnet, dass** die Lichtquelle (3) und der Lichtdetektor (4) des Reflexions-Lichttasters (2) durch eine Infrarot-Leuchtdiode und einen Infrarotdetektor, vorzugsweise mit Sende- bzw. Detektionsmaxima bei einer Wellenlänge λ zwischen 850nm und 900nm, gebildet ist.

7. Wechselrichtergehäuse (15) nach einem der Ansprüche 1 bis 6, **dadurch gekennzeichnet, dass** die Signallichtquelle (9) zur Aussendung von Licht im sichtbaren Wellenlängenbereich durch eine RGB-Leuchtdiode gebildet ist.

8. Wechselrichtergehäuse (15) nach einem der Ansprüche 1 bis 7, **dadurch gekennzeichnet, dass** die Aufnahme (25) für die Platine (14) derart vorgesehen ist, dass die Platine (14) in einem Winkel (α) zwischen 10° und 170°, vorzugsweise im Wesentlichen 90°, zur Bedienfläche (6) angeordnet ist.

9. Wechselrichtergehäuse (15) nach einem der Ansprüche 1 bis 8, **dadurch gekennzeichnet, dass** die Bedienfläche (6) und bzw. oder die Umlenkfläche (13) des Lichtleiters (8) poliert ausgebildet ist.

## Claims

1. Inverter housing (15) for an inverter (10), comprising at least two housing parts (16, 17) which can be detachably connected to one another via fastening elements (19), comprising a connection region (21) and comprising an operating region (20) provided on one housing part (16, 17), wherein an optoelectronic operating unit (1) for operating the inverter (10) is provided, the operating unit comprising at least one proximity photoelectric sensor (2) each having a light source (3) and a light detector (4) arranged next to the light source (3), comprising evaluation electronics (5), and comprising an operating surface (6) arranged above the light source (3) and the light detector (4) of each proximity photoelectric sensor (2), which operating surface is intended for operating the proximity photoelectric sensor (2) as a result of an object (7) approaching, wherein a optical waveguide (8) connected to one housing part (17) is arranged between each operating surface (6) and the light source (3) and the light detector (4) of a proximity photoelectric sensor (2), the other housing part (16) has a receptacle (25) for a circuit board (14) which contains the proximity photoelectric sensor (2) of the optoelectronic operating unit (1), a signal light source (9) for emitting light in the visible wavelength range is arranged in such a way that the light in the visible wavelength range emitted by the signal light source (9) can be projected onto the operating surface (6) via the optical waveguide (8), and the connection region (21) is arranged below the operating region (20).

2. Inverter housing (15) according to claim 1, **characterised in that** the operating surface (6) or the optical waveguide (8) comprising the operating surface (6) is produced together with a housing part (16, 17), preferably in a two-component or multi-component injection moulding process.

3. Inverter housing (15) according to either claim 1 or claim 2, **characterised in that** a seal (18) is arranged between the at least two housing parts (16, 17).

4. Inverter housing (15) according to any of claims 1 to 3, **characterised in that** the signal light source (9) of the optoelectronic operating unit (1) is arranged between the light source (3) and the light detector (4) of a proximity photoelectric sensor (2).

5. Inverter housing (15) according to any of claims 1 to 4, **characterised in that** the operating surface (6) of the optoelectronic operating unit (1) is formed by the optical waveguide (8).

6. Inverter housing (15) according to any of claims 1 to 5, **characterised in that** the light source (3) and the light detector (4) of the proximity photoelectric sensor (2) is formed by an infrared light-emitting diode and an infrared detector, preferably having transmitting and detection maxima, respectively, at a wavelength A between 850 nm and 900 nm.

7. Inverter housing (15) according to any of claims 1 to 6, **characterised in that** the signal light source (9) for emitting light in the visible wavelength range is formed by an RGB light-emitting diode.

8. Inverter housing (15) according to any of claims 1 to 7, **characterised in that** the receptacle (25) for the circuit board (14) is provided in such a way that the circuit board (14) is arranged at an angle (α) between 10° and 170°, preferably substantially 90°, with respect to the operating surface (6).

9. Inverter housing (15) according to any of claims 1 to 8, **characterised in that** the operating surface (6) and/or the deflection surface (13) of the optical waveguide (8) is polished.

## Revendications

1. Boîtier d'onduleur (15) pour un onduleur (10) comprenant au moins deux parties de boîtier (16, 17) pouvant être assemblées de manière amovible au moyen d'éléments de fixation (19), une zone de raccordement (21) et une zone de commande (20) prévue sur une partie de boîtier (16, 17), dans lequel une unité de commande optoélectronique (1) est prévue pour commander l'onduleur (10), laquelle comprend au moins un capteur de lumière réfléchie (2) comprenant une source de lumière (3) correspondante et un détecteur de lumière (4) correspondant disposé à côté de la source de lumière (3), un système électronique de traitement (5), et une surface de commande (6) située au-dessus de la source de lumière (3) et du détecteur de lumière (4) de chaque capteur de lumière réfléchie (2) et destinée à commander le capteur de lumière réfléchie (2) par le rapprochement d'un objet (7), dans lequel un guide de lumière (8) relié à une partie de boîtier (17) est disposé entre chaque surface de commande (6) et la source de lumière (3) et le détecteur de lumière (4) d'un capteur de lumière réfléchie (2), l'autre partie de boîtier (16) comporte un logement (25) pour une carte de circuit imprimé (14) qui contient le capteur de lumière réfléchie (2) de l'unité de commande optoélectronique (1), une source de signal lumineux (9) destinée à émettre de la lumière dans la plage des longueurs d'onde visibles est disposée de telle sorte que la lumière émise par la source de signal lumineux (9) dans la plage des longueurs d'onde visibles peut être projetée sur la surface de commande (6) par l'intermédiaire du guide de lumière (8) et que la zone de raccordement (21) est disposée en dessous de la zone de commande (20).

2. Boîtier d'onduleur (15) selon la revendication 1, **caractérisé en ce que** la surface de commande (6) resp. le guide de lumière (8) présentant la surface de commande (6) est fabriqué conjointement avec une partie de boîtier (16, 17), de préférence par moulage par injection à deux ou plusieurs composants.

3. Boîtier d'onduleur (15) selon la revendication 1 ou 2, **caractérisé en ce qu'**un joint (18) est disposé entre au moins les deux parties de boîtier (16, 17).

4. Boîtier d'onduleur (15) selon l'une des revendications 1 à 3, **caractérisé en ce que** la source de signal lumineux (9) de l'unité de commande optoélectronique (1) est disposée entre la source de lumière (3) et le détecteur de lumière (4) d'un capteur de lumière réfléchie (2).

5. Boîtier d'onduleur (15) selon l'une des revendications 1 à 4, **caractérisé en ce que** la surface de commande (6) de l'unité de commande optoélectronique (1) est formée par le guide de lumière (8).

6. Boîtier d'onduleur (15) selon l'une des revendications 1 à 5, **caractérisé en ce que** la source de lumière (3) et le détecteur de lumière (4) du capteur de lumière réfléchie (2) sont formés par une diode électroluminescente infrarouge et un détecteur infrarouge, ayant de préférence des maximums d'émission et de détection respectifs à une longueur d'onde A comprise entre 850 nm et 900 nm.

7. Boîtier d'onduleur (15) selon l'une des revendications 1 à 6, **caractérisé en ce que** la source de signal lumineux (9) destinée à émettre de la lumière dans la plage des longueurs d'onde visibles est formée par une diode électroluminescente RVB.

8. Boîtier d'onduleur (15) selon l'une des revendications 1 à 7, **caractérisé en ce que** le logement (25) pour la carte de circuit imprimé (14) est conçu de telle sorte que la carte de circuit imprimé (14) est disposée selon un angle (α) compris entre 10° et 170°, de préférence sensiblement 90°, par rapport à la surface de commande (6).

9. Boîtier d'onduleur (15) selon l'une des revendications 1 à 8, **caractérisé en ce que** la surface de commande (6) et/ou la surface de déviation (13) du guide de lumière (8) sont polies.
